(19) Europäisches Patentamt
European Patent Office
Office européen des brevets

(11) **EP 2 174 147 B1**

(12) **EUROPÄISCHE PATENTSCHRIFT**

(45) Veröffentlichungstag und Bekanntmachung des Hinweises auf die Patenterteilung:
**07.03.2012 Patentblatt 2012/10**

(21) Anmeldenummer: **08786721.4**

(22) Anmeldetag: **31.07.2008**

(51) Int Cl.:
**G01R 15/20** (2006.01)

(86) Internationale Anmeldenummer:
**PCT/EP2008/060100**

(87) Internationale Veröffentlichungsnummer:
**WO 2009/019200 (12.02.2009 Gazette 2009/07)**

(54) **ANORDNUNG ZUR MESSUNG EINES IN EINEM ELEKTRISCHEN LEITER FLIESSENDEN STROMS**

ARRANGEMENT FOR MEASURING A CURRENT FLOWING THROUGH AN ELECTRICAL CONDUCTOR

DISPOSITIF DE MESURE D'UN COURANT CIRCULANT DANS UN CONDUCTEUR ÉLECTRIQUE

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **03.08.2007 DE 102007036674**

(43) Veröffentlichungstag der Anmeldung:
**14.04.2010 Patentblatt 2010/15**

(73) Patentinhaber: **Epcos AG
81669 München (DE)**

(72) Erfinder:
• **RÖLLGEN, Bernhard
81673 München (DE)**
• **NEUDECKER, Martin
85435 Erding (DE)**

(74) Vertreter: **Epping - Hermann - Fischer
Patentanwaltsgesellschaft mbH
Ridlerstrasse 55
80339 München (DE)**

(56) Entgegenhaltungen:
**EP-A- 1 067 391          EP-A- 1 762 852
DE-B4-102005 024 075**

EP 2 174 147 B1

**Beschreibung**

Aus der Druckschrift DE 10 2005 024 075 B4 ist eine Vorrichtung zur Messung eines in einem elektrischen Leiter fließenden Stroms bekannt.

Eine zu lösende Aufgabe besteht darin, eine Anordnung und ein Verfahren zur Messung eines in einem elektrischen Leiter fließenden Stroms anzugeben, welche unabhängig von äußeren magnetischen Einflüssen eine korrekte Messung ermöglicht.

Diese Aufgabe wird durch eine Anordnung zur Messung eines in einem elektrischen Leiter fließenden Stroms gemäß Anspruch 1 gelöst.

Die Anordnung weist einen mit einem Luftspalt versehenen Magnetkreis zur Kopplung mit einem elektrischen Leiter auf. Im Luftspalt des Magnetkreises befindet sich ein Steuerkern, der zur Steuerung des Luftspalts vorgesehen ist. Der Steuerkern weist eine Steuerwicklung zu seiner magnetischen Sättigung auf. In dem Luftspalt des Magnetkreises ist ein magnetfeldsensitives Bauelement zur Messung des vom elektrischen Leiter erzeugten Magnetfeldes angeordnet. Das magnetfeldsensitive Bauelement ist einseitig des Steuerkerns angeordnet. In einer Ausführungsform kann ein zweites magnetfeldsensitives Bauelement auf der dem ersten magnetfeldsensitiven Bauelement gegenüberliegenden Seite des Steuerkerns angeordnet sein. In der Nähe des ersten magnetfeldsensitiven Bauelements befinden sich mehrere zusätzliche Elemente. Diese Elemente eignen sich unabhängig von dem Steuerkern zur Führung von Magnetfeldern in der Umgebung des magnetfeldsensitiven Bauelements.

In einer bevorzugten Ausführungsform ist ein erstes Element innerhalb des Steuerkerns angeordnet, ein zweites außerhalb des Steuerkerns.

Der Steuerkern ist bevorzugt in dem Luftspalt des Magnetkreises angeordnet, so dass Spalte ober- und unterhalb zwischen dem Steuerkern und dem Magnetkreis entstehen.

In einer weiteren Ausführungsform ist der Luftspalt asymmetrisch angeordnet, so dass vorzugsweise unterschiedlich große Spalte ober- und unterhalb zwischen dem Steuerkern und dem Magnetkreis entstehen.

Die in der Nähe des Steuerkerns befindlichen Elemente sind bevorzugt magnetisierbar.

Bevorzugt weisen die zusätzlichen Elemente eine Permeabilitätszahl auf, die größer als 1 ist.

Für die zusätzlichen Elemente eignen sich besonders weichmagnetische Materialien, die eine Permeabilitätszahl aufweisen, die größer oder gleich der Permeabilitätszahl des Steuerkerns ist. Dafür geeignet sind vorzugsweise Materialien, die auch für den Steuerkern Verwendung finden.

Die zusätzlichen Elemente sind bevorzugt in der Nähe eines ersten magnetfeldsensitiven Bauelements angeordnet, sodass mögliche magnetische Störfelder effektiv in der Nähe des magnetfeldsensitiven Bauelements gebündelt und durch das magnetfeldsensitive Bauelement hindurchgeführt werden können. In einer Ausführungsform ist es auch möglich, dass die Elemente als ein integraler Bestandteil eines einteiligen Steuerkerns ausgebildet sind. Hierbei ist eine Auswölbung des Steuerkerns und eine Verdickung des Steuerkerns in der näheren Umgebung des magnetfeldsensitiven Bauelements möglich, sodass zwischen einem der zusätzlichen Elemente und dem magnetfeldsensitiven Bauelement ein möglichst kleiner Luftspalt zustande kommt.

Die Bereiche der Verdickung oder Auswölbung des Steuerkerns weisen auch bei Sättigung der Steuerkerne noch eine Restpermeabilität auf.

In einer weiteren Ausführung bestehen die zusätzlichen Elemente aus mehreren Einzelteilen, die jeweils zu einem zusätzlichen Element zusammengefügt werden können.

Bevorzugt weisen die zusätzlichen Elemente bei vollständiger Sättigung des Steuerkerns durch die Steuerwicklungen eine Restpermeabilität auf, sodass störende Magnetfelder auch bei Sättigung des Steuerkerns weiterhin von den zusätzlichen Elementen gebündelt und durch das magnetfeldsensitive Bauelement geführt werden können.

In einer bevorzugten Ausführungsform bestehen die zusätzlichen Elemente aus ferromagnetischem Material, beispielsweise einem Ferrit, einer nanokristallinen Metalllegierung oder aus Permalloy. Es eignen sich jedoch auch andere Materialien, die ferromagnetische Eigenschaften aufweisen.

In einer Ausführungsform weist der Magnetkreis eine zusätzliche Wicklung auf. Durch die zusätzliche Wicklung kann der Magnetkreis durch einen kurzen Stromimpuls magnetisiert werden. Nach dem Stromimpuls weist der Magnetkreis eine definierte Remanenz auf, die zur Einstellung des Nullpunktes herangezogen werden kann.

Um eine zuverlässige Messung des in dem elektrischen Leiter fließenden Stroms zu ermöglichen, ist der Magnetkreis in der Lage, den elektrischen Leiter in seinem Querschnitt vollständig zu umgreifen.

In einer bevorzugten Ausführungsform ist der Steuerkern als Ferritkern ausgebildet. Dabei ist der Ferritkern besonders bevorzugt als rechteckiger Rahmen ausgebildet, der auf mindestens einer Seite des Rahmens eine Steuerwicklung zur Sättigung des Ferritkerns aufweist. In einer besonders effizienten Variante sind Steuerwicklungen auf zwei gegenüberliegenden Seiten des Rahmens angeordnet. Durch die Ausbildung des Steuerkerns in dieser Form kann eine effiziente Sättigung des Steuerkerns erreicht werden.

Dadurch, dass in dem Magnetkreis nur ein Steuerkern angeordnet ist, kann dieser im Vergleich zu einem Aufbau mit zwei Steuerkernen mehr als die doppelte Anzahl Windungen auf den Steuerkern aufweisen, sodass bei gleichem Drahtdurchmesser der Steuerwicklungen die doppelte Anzahl an Amperewindungen verfügbar sind. Dies ermöglicht die Messung sehr großer Ströme, ohne dass die Steuerkerne vom Primärstrom aus der Sättigung getrieben werden. Bei sehr großen Strömen, die im Bereich von ca. 1000 liegen, würde der Primärstrom dem Steuerstrom in einem der Schenkel des Steuerkerns entgegenwirken und ihn so aus der Sättigung treiben.

Das magnetfeldsensitive Bauelement ist bevorzugt ein Hall-Sensor.

Wird ein Hall-Sensor von einem Strom durchflossen und ist in einem senkrecht dazu verlaufendes Magnetfeld gebracht, liefert er eine Ausgangsspannung, die proportional zum Produkt aus magnetischer Feldstärke und Strom ist.

Zur Bestimmung des in dem elektrischen Leiter fließenden Stroms werden verschiedene Messungen mit Hilfe des Hall-Sensors durchgeführt.

Die oben genannte Aufgabe wird ebenfalls durch eine Verfahren zur Messung eines in einem elektrischen Leiter fließenden Stroms gemäß Anspruch 13 gelöst.

Magnetfelder in der Umgebung des magnetfeldsensitiven Bauelements, die nicht durch den elektrischen Leiter oder die Steuerwicklung hervorgerufen werden, können die Messungen in erheblichem Ausmaß verschlechtern.

Eine erste Messung wird bei gesättigtem Steuerkern, eine weitere bei ungesättigtem Steuerkern durchgeführt. Durch die außen angebrachten zusätzlichen magnetisierbaren Elemente werden externe magnetische Störfelder derart beeinflusst, dass sich Beiträge externer magnetischer Störfelder in den Gleichungen zur Berechnung der Stromstärke gleichen und somit eliminiert werden können.

Das erste zusätzliche Element im Inneren des Steuerkerns wird benötigt, um die Empfindlichkeit für externe Magnetfelder im Fall der Sättigung des Steuerkerns zu erhöhen, sodass sich die Beiträge externer magnetischer Störfelder in den Gleichungen zur Berechnung des Stromstärke gleichen. Vorzugsweise befindet sich zwischen dem Steuerkern und dem Magnetkreis jeweils ober- und unterhalb ein Luftspalt. Der zusätzliche Luftspalt unterhalb des Steuerkerns unterstützt die Wirkung des außen angebrachten zusätzlichen Elementes aus magnetisierbarem Material. In dem Luftspalt unterhalb des Steuerkerns kann ein weiteres magnetfeldsensitives Bauelement zwischen dem Steuerkern und dem Magnetkreis angeordnet sein. Durch paralleles Auslesen und Mittelung der Messwerte oder der Messergebnisse kann die Messgenauigkeit erhöht werden.

Aus den zwei Messungen bei gesättigtem und ungesättigtem Steuerkern kann unter Berücksichtigung von bestimmten Faktoren, die sich durch die Sensitivität des Hall-Sensors bei gesättigtem beziehungsweise ungesättigtem Steuerkern ergeben, über bekannte Gleichungen die Stromstärke des durch den elektrischen Leiter fließenden Stroms berechnet werden.

Durch die neu hinzugefügten Elemente aus bevorzugt weichmagnetischem Material können störende Einflüsse durch externe Magnetfelder in den Gleichungen sowohl bei gesättigtem Steuerkern als auch bei ungesättigtem Steuerkern eliminiert werden, da diese Beiträge durch die zusätzlichen Elemente aneinander angeglichen werden können. Dadurch kann das lineare Gleichungssystem auf einfache Art und Weise gelöst werden und die Stromstärke des elektrischen Leiters ermittelt werden.

Durch die sowohl innerhalb des Steuerkerns als auch außerhalb des Steuerkerns angebrachten zusätzlichen Elemente werden die Eintrittswinkel für externe magnetische Störfelder bei gesättigtem und ungesättigtem Steuerkern angeglichen. In diesem Fall heben sich die Beiträge der externen Störmagnetfelder auf, die Stromstärke kann durch einfache Subtraktion der beiden Gleichungen ermittelt werden.

In der Messung werden physikalische Größen oft in analoge elektrische Größen umgewandelt. Bei der Quantisierung wird der Messbereich der analogen Größe in eine endliche Zahl aneinander angrenzender Teilbereiche (Intervalle) aufgeteilt und jedem davon ein Wert eines endlichen symbolischen Systems zugeordnet (z.B. eine ganze Zahl). Als Auflösung wird die Anzahl der verwendeten Teilbereiche der analogen Größe, bei binären symbolischen Systemen auch ihre Zweierpotenz (Auflösung in Bit) bezeichnet, jedoch bei gleich großen Intervallen auch die Größe der Intervalle selbst.

Die Quantisierungsschritte geben den Wert für das Messsignal in diskreter Form wieder.

Dabei werden folgende zwei Gleichungen aufgestellt:

I.

$$R_{low} = n + S_{low} * I_{DC} + S_{Bl} * B * \sin(\alpha)$$

II.

$$R_{high} = n + S_{high} * I_{DC} + S_{Bh} * B * \sin(\alpha)$$

In den oben angeführten Gleichungen gibt $R_{low}$ die Anzahl der Quantisierungsschritte bei Sättigung des Steuerkerns an. $R_{high}$ gibt die Anzahl bei ungesättigtem Steuerkern wieder. Die Variable n gibt den Nullpunkt des magnetfeldsensitiven Bauelements in Quantisierungsschritten an, bei dem im elektrischen Leiter 0A Strom und am magnetfeldsensitiven Bauelement 0 Tesla Flussdichte anliegen. Die Variablen $S_{low}$ und $S_{high}$ geben die Sensitivität des magnetfeldsensitiven Bauelements bei gesättigtem beziehungsweise bei ungesättigtem Steuerkern an. Die Variable B bezeichnet die magnetische Flussdichte eines externen Magnetfeldes und die Variable $\alpha$ gibt den Winkel an, aus dem das externe Magnetfeld auf das magnetfeldsensitive Bauelement trifft. Die Variable $I_{DC}$ gibt die Stromstärke des Strom durchflossenen Leiters an, die in der Messung ermittelt werden soll.

Die zusätzlich in der Nähe des magnetfeldsensitiven Bauelements angeordneten bevorzugt weichmagnetischen Elemente ermöglichen es nun, die Variablen $S_{Bl}$ und $S_{Bh}$ anzugleichen. Dadurch lässt sich das lineare Gleichungssystem zur Bestimmung der Stromstärke $I_{DC}$ auf einfache Art und Weise lösen.

Da $S_{Bl}$ und $S_{Bh}$ identisch sind und die Eintrittswinkel der externen Störmagnetfelder bei gesättigtem und ungesättigtem Steuerkern durch den oben beschriebenen Aufbau identisch sind, kann durch Subtraktion der Gleichung (I.) von der Gleichung (II.), oder umgekehrt, $I_{DC}$ ermittelt werden.

$$I_{DC} = (R_{low} - R_{high}) / (S_{low} - S_{high})$$

Die Anordnung wird im Folgenden anhand von Ausführungsbeispielen und den dazugehörigen Figuren näher erläutert.

Die nachfolgend beschriebenen Zeichnungen sind nicht als maßstabsgetreu aufzufassen. Vielmehr können zur besseren Darstellung einzelne Dimensionen vergrößert, verkleinert oder auch verzerrt dargestellt sein.

Elemente, die einander gleichen oder die die gleiche Funktion übernehmen, sind mit gleichen Bezugszeichen bezeichnet.

Figur 1    zeigt eine beispielhafte Anordnung zur Messung eines in einem elektrischen Leiter fließenden Stroms.

Figur 2    zeigt einen Ausschnitt einer beispielhaften Anordnung zur Messung eines in einem elektrischen Leiter fließenden Stroms.

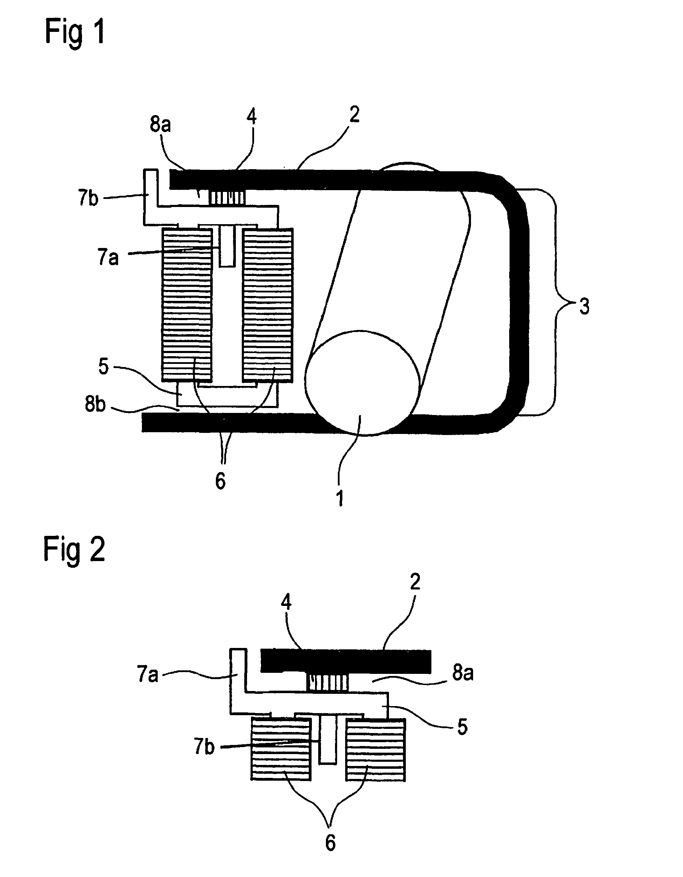

In Figur 1 ist eine mögliche Variante der beispielhaften Anordnung zur Messung eines in einem elektrischen Leiter 1 fließenden Stroms gezeigt, bei der ein Magnetkreis 2, der aus Ferrit bestehen kann, einen elektrischen Leiter umgreift. Der Magnetkreis 2 weist auf einer Seite einen Luftspalt 3 auf, in dem sich ein magnetfeldsensitives Bauelement 4 befindet. Zur Steuerung des Luftspalts 3 befindet sich in dem Luftspalt 3 ein Steuerkern 5. Der Steuerkern 5 ist mittig in dem Luftspalt 3 angeordnet, so dass zwischen dem U-förmigen Magnetkreis 2 und dem Steuerkern 5 beidseitig des Steuerkerns 5 jeweils ein Spalt 8a, 8b vorhanden ist. In dem ersten Spalt 8a ist das magnetfeldsensitive Bauelement 4 angeordnet. Die Dicke des magnetfeldsensitiven Bauelements 4 und die Höhe des Spalts 8a sind annähernd gleich groß, so dass das magnetfeldsensitive Bauelement 4 sowohl an dem Magnetkreis 2 als auch an dem Steuerkern 5 anliegt. Der Steuerkern 5 weist Steuerwicklungen 6 auf, die den Steuerkern 5 in die magnetische Sättigung bringen können. Der Steuerkern 5 weist in der Nähe des magnetfeldsensitiven Bauelements 4 zusätzliche magnetisierbare Elemente 7a, 7b auf. Ein erstes zusätzliches Element 7a ist bevorzugt innerhalb des Steuerkerns 5 angeordnet. Das zusätzliche Element ist bevorzugt stabförmig ausgebildet. Ein weiteres zusätzliches magnetisierbares Element 7b ist vorzugsweise am Rand des oberen Schenkels des Steuerkerns 5 angeordnet. Das äußere zusätzliche Element 7b ist somit außen am Steuerkern 5 angeordnet, wobei es in einer bevorzugten Ausführungsform als ein Teil des Steuerkerns 5 gebildet sein kann. In den unteren Spalt 8b kann ein weiteres magnetfeldsensitives Bauelement 4 eingebracht werden, um durch eine doppelte Messung die Messgenauigkeit zu erhöhen.

In Figur 2 ist ein Ausschnitt der beispielhaften Anordnung zur Messung eines in einem elektrischen Leiter 1 fließenden Stroms gezeigt. Der Ausschnitt zeigt den Bereich um das magnetfeldsensitive Bauelement 4. Das magnetfeldsensitive Bauelement 4 befindet sich in dem Spalt 8a zwischen dem Steuerkern 5 und dem Magnetkreis 2. Der Steuerkern 5 weist Steuerwicklungen 6 auf, die zur Sättigung des Steuerkerns 5 dienen. In der Nähe des magnetfeldsensitive Bauelement 4 befinden sich zusätzliche magnetisierbare Elemente 7a, 7b, die bevorzugt aus weichmagnetischem Material bestehen. Ein erstes zusätzliches Element 7a befindet sich innerhalb des Steuerkerns 5 zwischen den Steuerwicklungen 6. In einer bevorzugten Ausführungsform ist das zusätzliche Element 7a stabförmig ausgebildet. Ein weiteres zusätzliches Element 7b ist außen am Steuerkern 5 angebracht. Das zusätzliche Element 7b ist bevorzugt als Teil des Steuerkerns 5 ausgebildet. Die zusätzlichen magnetisierbaren Elemente weisen auch bei vollständiger Sättigung des Steuerkerns 5 eine Restpermeabilität auf. Durch die beiden zusätzlichen magnetisierbaren Elemente 7a, 7b können die Beiträge der störenden äußeren Magnetfelder in den Gleichungen des durch den elektrischen Leiter fließenden Stroms angeglichen werden, so dass die Beiträge in den Gleichungen herausgekürzt werden können.

Obwohl in den Ausführungsbeispielen nur eine beschränkte Anzahl möglicher Weiterbildungen der Erfindung beschrieben werden konnte, ist die Erfindung nicht auf diese beschränkt. Es ist prinzipiell möglich, eine andere Anzahl der Steuerwicklungen oder eine andere Form des Magnetkreises für die Anordnung zu verwenden. Die Erfindung ist nicht auf die Anzahl der schematisch dargestellten Elemente beschränkt.

Die Beschreibung der hier angegebenen Gegenstände und Verfahren ist nicht auf die einzelnen speziellen Ausführungsformen beschränkt. Vielmehr können die Merkmale der einzelnen Ausführungsformen - soweit technisch sinnvoll - beliebig miteinander kombiniert werden.

Bezugszeichenliste

| | |
|---|---|
| 1 | elektrischer Leiter |
| 2 | Magnetkreis |
| 3 | Luftspalt |
| 4 | magnetfeldsensitives Bauelement |
| 5 | Steuerkern |
| 6 | Steuerwicklung |
| 7a, 7b | zusätzliche Elemente |
| 8a, 8b | Spalt |

**Patentansprüche**

1.   Anordnung zur Messung eines in einem elektrischen Leiter (1) fließenden Stroms, aufweisend

 - einen Magnetkreis (2) mit Luftspalt (3) zur Kopplung mit dem elektrischen Leiter (1),
 - ein oder mehrere im Luftspalt (3) des Magnetkreises (2) angeordnete magnetfeldsensitive Bauelemente (4) zur Messung des vom elektrischen Leiter (1) erzeugten Magnetfelds,
 - einen Steuerkern (5) zur Steuerung des Luftspalts (3) , der in dem Luftspalt (3) angeordnet ist,
 - wobei der Steuerkern (5) eine Steuerwicklung (6) zur magnetischen Sättigung des Steuerkerns (5) aufweist,

 wobei ein magnetfeldsensitives Bauelement (4) auf einer ersten Seite des Steuerkerns (5) angeordnet ist und sich in der Nähe des magnetfeldsensitiven Bauelements (4) mehrere zusätzliche Elemente (7a, 7b) befinden, die unabhängig von dem Steuerkern (5) zur Führung von Magnetfeldern in der Umgebung des magnetfeldsensitiven Bauelements (4) geeignet sind, wobei ein erstes zusätzliches Element (7a) innerhalb des Steuerkerns (5) und ein zweites zusätzliches Element (7b) außerhalb des Steuerkerns (5) angeordnet ist.

2.   Anordnung nach Anspruch 1, bei der die zusätzlichen Elemente (7a, 7b) magnetisierbar sind.

3.   Anordnung nach einem der vorhergehenden Ansprüche, bei der die zusätzlichen Elemente (7a, 7b) eine Permeabilitätszahl von vorzugsweise > 1 aufweisen.

4.   Anordnung nach einem der vorhergehenden Ansprüche, bei der die zusätzlichen Elemente (7a, 7b) aus einem weichmagnetischen Material bestehen.

5.   Anordnung nach einem der vorhergehenden Ansprüche, bei der die zusätzlichen Elemente (7a, 7b) eine Permeabilitätszahl aufweisen, die größer oder gleich der Permeabilitätszahl des Steuerkerns (5) ist.

6.   Anordnung nach einem der vorhergehenden Ansprüche, bei der die zusätzlichen Elemente (7a, 7b) eine beliebige Form aufweisen oder jeweils aus mehreren Einzelelementen bestehen.

7. Anordnung nach einem der vorhergehenden Ansprüche, bei dem die zusätzlichen Elemente (7a, 7b) einen Teil des Steuerkerns (5) darstellen.

8. Anordnung nach einem der vorhergehenden Ansprüche, bei der die zusätzlichen Elemente (7a, 7b) eine Restpermeabilität aufweisen, wenn der Steuerkern (5) gesättigt ist.

9. Anordnung nach einem der vorhergehenden Ansprüche, bei der der Magnetkreis (2) eine zusätzliche wicklung aufweist.

10. Anordnung nach einem der vorhergehenden Ansprüche, bei der der Steuerkern (5) als Ferritkern ausgebildet ist.

11. Anordnung nach einem der vorhergehenden Ansprüche, bei der der Magnetkreis (2) und Steuerkern (5) voneinander beabstandet sind, so dass die Anordnung zwischen dem Magnetkreis (2) und dem Steuerkern (5) beidseitig jeweils einen Spalt (8a, 8b) aufweist.

12. Anordnung nach einem der vorhergehenden Ansprüche, bei der das magnetfeldsensitive Bauelement (4) ein Hall-Sensor ist.

13. Verfahren zur Messung eines in einem elektrischen Leiter (1) fließenden Stroms mit den Schritten:

   - Koppeln eines Magnetkreises (2) mit dem elektrischen Leiter (1), wobei der Magnetkreis (2) einen Luftspalt (3) und einen in dem Luftspalt (3) angeordneten Steuerkern (5) zur Steuerung des Luftspalts (3) aufweist,
   - Messung eines ersten Magnetfelds bei gesättigtem Steuerkern (5) durch ein oder mehrere im Luftspalt (3) angeordnete magnetfeldsensitive Bauelemente (4);
   - Messung eines zweiten Magnetfelds bei ungesättigtem Steuerkern (5) durch das oder die magnetfeldsensitiven Bauelemente (4);
   - Eliminieren von störenden Einflüssen externer Magnetfelder durch Beeinflussen der störenden externen Magnetfelder durch ein erstes, innerhalb des Steuerkerns (5) angeordnetes zusätzliches Element (7a) und ein zweites, außerhalb des Steuerkerns (5) angeordnetes zusätzliches Element (7b), die unabhängig von dem Steuerkern (5) zur Führung von Magnetfeldern in der Umgebung eines magnetfeldsensitiven Bauelements (4) geeignet sind, so dass sich Beiträge zur Berechnung einer Stromstärke bei der ersten Messung und bei der zweiten Messung gleichen.

14. Verfahren nach Anspruch 13, wobei der Schritt des Eliminierens von störenden Einflüssen umfasst:

   - Erhöhen einer Empfindlichkeit zur Messung des externen Magnetfeldes bei gesättigtem Steuerkern (2) durch das erste, im Inneren des Steuerkerns (5) angeordnete zusätzliche Element (7a).

15. Verfahren nach Anspruch 13 oder 14, wobei der Schritt des Eliminierens von störenden Einflüssen umfasst:

   - Angleichen der Eintrittswinkel der externen Magnetfelder bei gesättigtem und bei ungesättigtem Steuerkern (2) durch sowohl das erste, im Inneren des Steuerkerns (5) angeordnetes zusätzliches Element (7a) als auch das zweite, außerhalb des Steuerkerns angeordnete zusätzliche Element (7b).

**Claims**

1. Arrangement for measuring a current flowing in an electrical conductor (1), having

   - a magnetic circuit (2) with an air gap (3) for coupling to the electrical conductor (1),
   - one or more magnetic-field-sensitive components (4) arranged in the air gap (3) of the magnetic circuit (2) for measuring the magnetic field induced by the electrical conductor (1),
   - a control core (5) for controlling the air gap (3) which is arranged in the air gap (3),
   - the control core (5) having a control winding (6) for the magnetic saturation of the control core (5),

   a magnetic-field-sensitive component (4) being arranged on a first side of the control core (5) and a plurality of additional elements (7a, 7b) being located in the vicinity of the magnetic-field-sensitive component (4), said additional elements being suitable, independently of the control core (5), for guiding magnetic fields in the vicinity of the magnetic-field-sensitive component (4), a first additional element (7a) being arranged within the control core (5) and a second additional element (7b) being arranged outside the control core (5).

2.  Arrangement according to Claim 1, in which the additional elements (7a, 7b) are magnetizable.

3.  Arrangement according to one of the preceding claims, in which the additional elements (7a, 7b) have a relative permeability of preferably > 1.

4.  Arrangement according to one of the preceding claims, in which the additional elements (7a, 7b) consist of a soft-magnetic material.

5.  Arrangement according to one of the preceding claims, in which the additional elements (7a, 7b) have a relative permeability which is greater than or equal to the relative permeability of the control core (5).

6.  Arrangement according to one of the preceding claims, in which the additional elements (7a, 7b) have any desired form or each comprise a plurality of individual elements.

7.  Arrangement according to one of the preceding claims, in which the additional elements (7a, 7b) represent part of the control core (5).

8.  Arrangement according to one of the preceding claims, in which the additional elements (7a, 7b) have a residual permeability when the control core (5) is saturated.

9.  Arrangement according to one of the preceding claims, in which the magnetic circuit (2) has an additional winding.

10. Arrangement according to one of the preceding claims, in which the control core (5) is in the form of a ferrite core.

11. Arrangement according to one of the preceding claims, in which the magnetic circuit (2) and the control core (5) are spaced apart from one another, with the result that the arrangement has a gap (8a, 8b) on each side between the magnetic circuit (2) and the control core (5).

12. Arrangement according to one of the preceding claims, in which the magnetic-field-sensitive component (4) is a Hall sensor.

13. Method for measuring a current flowing in an electrical conductor (1), having the following steps:

    - coupling a magnetic circuit (2) to the electrical conductor (1), the magnetic circuit (2) having an air gap (3) and a control core (5), arranged in the air gap (3), for controlling the air gap (3),
    - measuring a first magnetic field when the control core (5) is saturated by means of one or more magnetic-field-sensitive components (4) arranged in the air gap (3);
    - measuring a second magnetic field when the control core (5) is unsaturated by means of the magnetic-field-sensitive component(s) (4);
    - eliminating disruptive influences of external magnetic fields by influencing the disruptive external magnetic fields with a first additional element (7a) arranged within the control core (5) and a second additional element (7b) arranged outside the control core (5), said additional elements being suitable, independently of the control core (5), for guiding magnetic fields in the vicinity of a magnetic-field-sensitive component (4), with the result that contributions to the calculation of a current intensity in the first measurement and in the second measurement correspond to one another.

14. Method according to Claim 13, the step of eliminating disruptive influences comprising:

    - increasing a sensitivity for measuring the external magnetic field when the control core (2) is saturated by means of the first additional element (7a) arranged in the interior of the control core (5).

15. Method according to Claim 13 or 14, the step of eliminating disruptive influences comprising:

- matching the entry angles of the external magnetic fields when the control core (2) is saturated and unsaturated by means of both the first additional element (7a) arranged in the interior of the control core (5) and the second additional element (7b) arranged outside the control core.

## Revendications

1. Dispositif pour la mesure d'un courant passant dans un conducteur électrique (1), comprenant

   - un circuit magnétique (2) comportant un entrefer (3) pour le couplage au conducteur électrique (1),
   - un ou plusieurs éléments constitutifs sensibles au champ magnétique (4) disposés dans l'entrefer (3) du circuit magnétique (2) pour mesurer le champ magnétique généré par le conducteur électrique (1),
   - un noyau de commande (5) pour commander l'entrefer (3), lequel noyau est disposé dans l'entrefer (3),
   - dans lequel le noyau de commande (5) comprend un enroulement de commande (6) destiné à saturer magnétiquement le noyau de commande (5),

   dans lequel un élément constitutif sensible au champ magnétique (4) est disposé d'un premier côté du noyau de commande (5) et plusieurs éléments supplémentaires (7a, 7b) se trouvent à proximité de l'élément constitutif sensible au champ magnétique (4), lesquels éléments supplémentaires sont aptes à guider des champs magnétiques dans le voisinage de l'élément constitutif sensible au champ magnétique (4) indépendamment du noyau de commande (5), un premier élément supplémentaire (7a) étant disposé à l'intérieur du noyau de commande (5) et un second élément supplémentaire (7b) étant disposé à l'extérieur du noyau de commande (5).

2. Dispositif selon la revendication 1, dans lequel les éléments supplémentaires (7a, 7b) peuvent être magnétisés.

3. Dispositif selon l'une des revendications précédentes, dans lequel les éléments supplémentaires (7a, 7b) présentent de préférence une perméabilité relative > 1.

4. Dispositif selon l'une des revendications précédentes, dans lequel les éléments supplémentaires (7a, 7b) sont constitués d'un matériau magnétique doux.

5. Dispositif selon l'une des revendications précédentes, dans lequel les éléments supplémentaires (7a, 7b) présentent une perméabilité relative qui est supérieure ou égale à la perméabilité relative du noyau de commande (5).

6. Dispositif selon l'une des revendications précédentes, dans lequel les éléments supplémentaires (7a, 7b) présentent une forme quelconque ou sont chacun constitués de plusieurs éléments individuels.

7. Dispositif selon l'une des revendications précédentes, dans lequel les éléments supplémentaires (7a, 7b) constituent une partie du noyau de commande (5).

8. Dispositif selon l'une quelconque des revendications précédentes, dans lequel les éléments supplémentaires (7a, 7b) présentent une perméabilité résiduelle lorsque le noyau de commande (5) est saturé.

9. Dispositif selon l'une des revendications précédentes, dans lequel le circuit magnétique (2) comprend un enroulement supplémentaire.

10. Dispositif selon l'une des revendications précédentes, dans lequel le noyau de commande (5) est réalisé sous la forme d'un noyau de ferrite.

11. Dispositif selon l'une des revendications précédentes, dans lequel le circuit magnétique (2) et le noyau de commande (5) sont espacés l'un de l'autre de telle sorte que le dispositif présente de chaque côté un interstice (8a, 8b) respectif entre le circuit magnétique (2) et le noyau commande (5).

12. Dispositif selon l'une des revendications précédentes, dans lequel l'élément constitutif sensible au champ magnétique (4) est un capteur à effet Hall.

13. Procédé pour la mesure d'un courant passant dans un conducteur électrique (1), comprenant les étapes suivantes :

- couplage d'un circuit magnétique (2) au conducteur électrique (1), le circuit magnétique (2) comprenant un entrefer (3) et un noyau de commande (5) disposé dans l'entrefer (3) pour commander l'entrefer (3),
- mesure d'un premier champ magnétique lorsque le noyau de commande (5) est saturé au moyen d'un ou plusieurs éléments constitutifs sensibles au champ magnétique (4) disposés dans l'entrefer (3) ;
- mesure d'un second champ magnétique lorsque le noyau de commande (5) est non saturé au moyen du ou des élément(s) constitutif(s) sensible(s) au champ magnétique (4) ;
- élimination des influences perturbatrices du champ magnétique externe en agissant sur les champs magnétiques externes perturbateurs au moyen d'un premier élément supplémentaire (7a) disposé à l'intérieur du noyau de commande (5), et d'un second élément supplémentaire (7b) disposé à l'extérieur du noyau de commande (5), lesquels éléments supplémentaires sont aptes à guider des champs magnétiques dans le voisinage d'un élément constitutif sensible au champ magnétique (4) indépendamment du noyau de commande (5), de manière à égaliser les contributions au calcul d'un courant obtenu lors de la première mesure et de la seconde mesure.

**14.** Procédé selon la revendication 13, dans lequel l'étape d'élimination des influences perturbatrices comprend :

- l'augmentation de la sensibilité de la mesure du champ magnétique externe lorsque le noyau est saturé (2) au moyen du premier élément supplémentaire (7a) disposé à l'intérieur du noyau de commande (5).

**15.** Procédé selon la revendication 13 ou 14, dans lequel l'étape d'élimination des influences perturbatrices comprend :

- l'ajustement des angles d'entrée des champs magnétiques externes lorsque le noyau de commande (2) est saturé et non saturé en utilisant à la fois le premier élément supplémentaire (7a) disposé à l'intérieur du noyau de commande (5) et le second élément supplémentaire (7b) disposé à l'extérieur du noyau de commande.

# Fig 1

# Fig 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102005024075 B4